# EUROPEAN PATENT SPECIFICATION

(11) **EP 1 903 608 B1**
(45) Date of publication and mention of the grant of the patent: **24.04.2013**
(21) Application number: 06746502.1
(22) Date of filing: 17.05.2006
(51) Int. Cl.: H01L 27/146, H04N 5/335, G02B 3/00, G02B 5/20, H04N 5/225

(54) **SOLID-STATE IMAGE SENSOR**
Festkörperbildsensor
Détecteur d'image à l'état solide

(30) Priority: 08.07.2005 JP 2005200296
(43) Date of publication of application: 26.03.2008
(73) Proprietor: NIKON CORPORATION, Chiyoda-ku Tokyo 100-8331 (JP)
(72) Inventor: TAKAGI, Toru, NIKON CORPORATION, Tokyo 100-8331 (JP)
(74) Representative: Whitlock, Holly Elizabeth Ann
(86) International application number: PCT/JP2006/309799
(87) International publication number: WO 2007/007467

(56) References cited:
- JP-A- 2000 039 503
- JP-A- 2003 172 804
- JP-A- 2006 145 627
- US-A- 5 321 297
- US-A1- 2004 257 460
- US-A1- 2004 263 985

## Description

### TECHNICAL FIELD

The present invention relates to a solid state image sensor having a microlens.

### BACKGROUND ART

In recent years, video cameras and electronic cameras using solid state image sensors of a CCD (Charge Coupled Device) type, a CMOS (Complementary Metal Oxide Semiconductor) type, and the like are in wide use. The solid state image sensor has a photoelectric conversion part converting light received by a pixel to an electric signal, and in the solid state image sensor, a plurality of pixels are arranged in matrix, and signal lines and so on through which the electric signals of the photoelectric conversion parts of the respective pixels are read are arranged around the photoelectric conversion parts. Light entering from a subject via a lens of a video camera or an electronic camera using a solid state image sensor is imaged on the pixels arranged in matrix and is converted to the electric signals by the photoelectric conversion parts.

However, not all the lights imaged on the pixels are necessarily enter the photoelectric conversion parts via the signal lines and the like, and therefore, used is an art in which microlenses are arrange in matrix on a side where lights enter the pixels, and lights which have been useless are condensed in the photoelectric conversion parts by the microlenses, and this art is described in a patent document 1.
Further, a typical microlens is semispherical and its plane shape is circular, while a plane shape of a pixel is generally quadrangular, and thus the shape of the pixel and the plane shape of the microlens do not always match each other, so that the photoelectric conversion part has an area in which light is not fully condensed. To prevent this, a patent document 2 describes an art to make the plane shape of a microlens quadrangular or to make the plane shape of a pixel and the plane shape of a microlens polygonal.
Patent document 1: Japanese Unexamined Patent Application Publication No. Sho 60-59752
Patent document 2: Japanese Unexamined Patent Application Publication No. Hei 5-326913
US Patent 5,321,297 relates to a solid state image pickup device having light conversion lens formed on a strip layer. Light is directed to each photosensitive section by adjusting the curvature or thickness of each light converging lens above the photosensitive section, by taking into account that each pixel has a longer side in the row direction than the side in the column direction. A strip layer is formed above a plurality of photosensitive sections, disposed in a row direction. Light converging lenses are formed on each strip layer to obtain a desired curvature or thickness.
US 2004257460 discloses a solid state imaging device having a stacked microlenses array.

### DISCLOSURE OF THE INVENTION

### PROBLEMS TO BE SOL VED BY THE INVENTION

In a solid state image sensor having a microlens, there has been a problem that it is difficult to efficiently condense lights in a photoelectric conversion part since, generally, the shape of a pixel of the solid state image sensor is quadrangular, while the plane shape of the microlens is circular. To solve this, there has been considered a method to make the shape of the pixel and the plane shape of the microlens polygonal, but they are not actually easy to design and manufacture. Moreover, there is a problem that an focusing efficiency in the photoelectric conversion part is not necessarily improved only by making the plane shape of the microlense quadrangular.

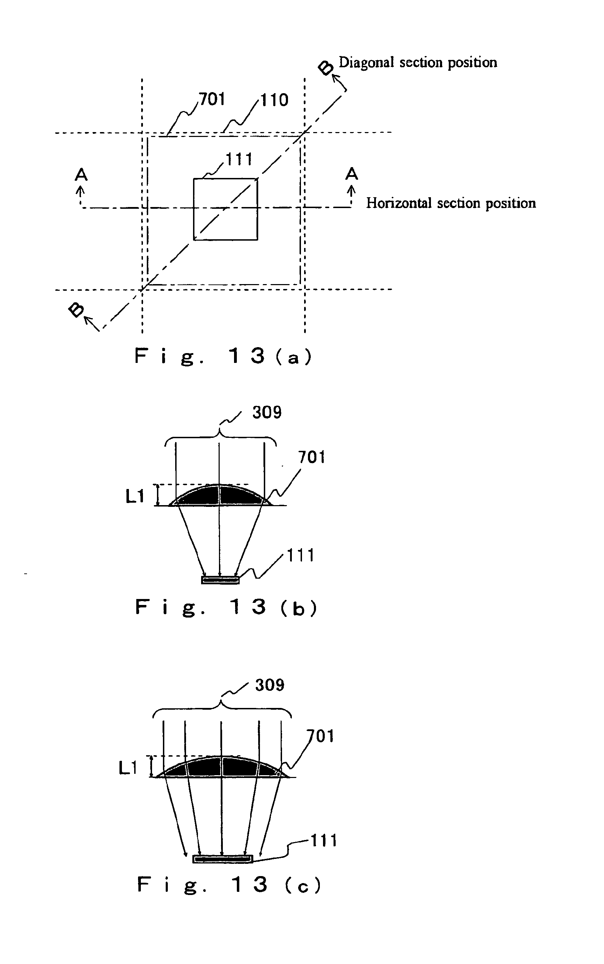

The problem of the conventional art will be described by using Figs. 13. Fig. 13(a) is a plane view of a typical solid state image sensor seen from above, where 701 denotes a quadrangular microlens according to a conventional art, 111 denotes a photoelectric conversion part such as a photodiode, 110 denotes a pixel among pixels arranged in matrix, A denotes a horizontal section position connecting centers of opposed sides of the pixel 110 and cutting the pixel 110 in a horizontal direction, and B denotes a diagonal section position cutting the pixel 110 in a diagonal direction. Figs. 13(b) and (c) are views showing section shapes of the microlens 701 and the photoelectric conversion part 111 and optical condensing images when they are cut along the horizontal section position A and the diagonal section position B, in which 309 denotes incoming lights and L1 denotes a thickness of the microlens 701.

Here, since a diagonal length is longer than a length of each side of the photoelectric conversion part 111, the diagonal section shape of the microlens 701 in Fig. 13(c) is longer than a horizontal section shape of the microlens 701 in Fig. 13(b), and the photoelectric conversion part 111 cut along the diagonal section position B in Fig. 13(c) is also longer.
However, to realize efficient optical condensing in the photoelectric conversion part 111 by the horizontal section shape of the microlens 701 in Fig. 13(b) without changing the thickness L1 of the lens, a curvature radius becomes large in the diagonal section shape of the microlens 701 in Fig. 13(c), which makes it difficult to fully condense light in the photoelectric conversion part 111.

As described above, there has been a problem that only by making the plane shape of the microlens 701 quadrangular so as to match the shape of the pixel 110 of the solid state image sensor, it is not possible to improve an focusing efficiency in the photoelectric conversion part 11.
It is an object of the present invention to provide a solid state image sensor capable of realizing a good focusing efficiency in the photoelectric conversion part 111 even if the shape of the pixel 110 is quadrangular as defined in claims 1 and 7.

### MEANS FOR SOL VING THE PROBLEMS

Aspects of the present invention are set out in the appended claims.

### EFFECT OF THE INVENTION

According to the solid state image sensor of the present invention, even if the shape of a pixel is quadrangular, an focusing efficiency in four corners is improved and thus it is possible to obtain a good focusing efficiency, and therefore, even with the same amount of light, a signal output from a photoelectric conversion part is increased, and sensitivity of the solid state image sensor can be improved.

### BRIEF DESCRIPTION OF THE DRAWINGS

Fig. 1 is an explanatory view showing the structure of a solid state image sensor of a first embodiment of the present invention;
Figs. 2 are explanatory views showing the structure of a unit of pixel 60 of the first embodiment of the present invention;
Fig. 3a is an auxiliary view used to describe a shape of a microlens of a first comparative embodiment not making part of the present invention;
Fig. 3b is an auxiliary view used to describe the shape of the microlens of the first embodiment of the present invention
Figs. 4 are explanatory views showing the structure of a unit of pixel 60 of a second comparative embodiment not making part of the present invention;
Figs. 5 are explanatory views used to describe a method of manufacturing a microlens of the second comparative embodiment not making part of the present invention;
Figs. 6 are explanatory views used to describe the method of manufacturing the microlens of the second comparative embodiment not making part of the present invention;
Figs. 7 are explanatory views used to describe the method of manufacturing the microlens of the second comparative embodiment not making part of the present invention;
Figs. 8 are explanatory views showing the structure of a unit of pixel 60 of a third embodiment of the present invention;
Figs. 9 are auxiliary views used to describe shapes of a second lens of the third embodiment of the present invention;
Figs. 10 are auxiliary views used to describe the shape of the second lens of the third embodiment of the present invention;
Fig. 11 is an auxiliary view used to describe an optical condensing condition of the third embodiment of the present invention;
Figs. 12 are auxiliary views showing optical condensing conditions in a case where a lens thickness is large; and
Figs. 13 are explanatory views showing the structure of a unit of pixel 60 according to a conventional art.

### BEST MODE FOR CARRYING OUT THE INVENTION

### (First Embodiment)

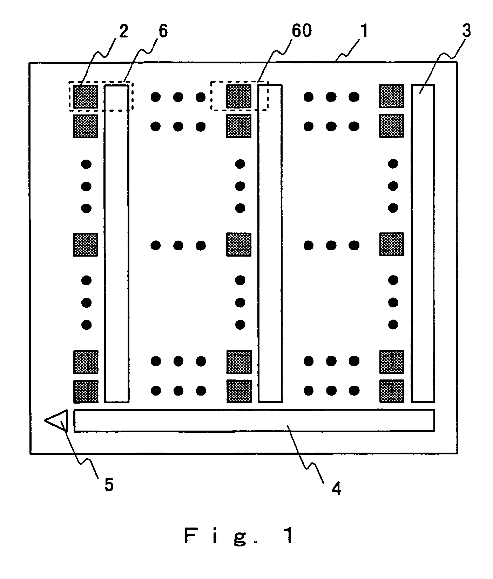

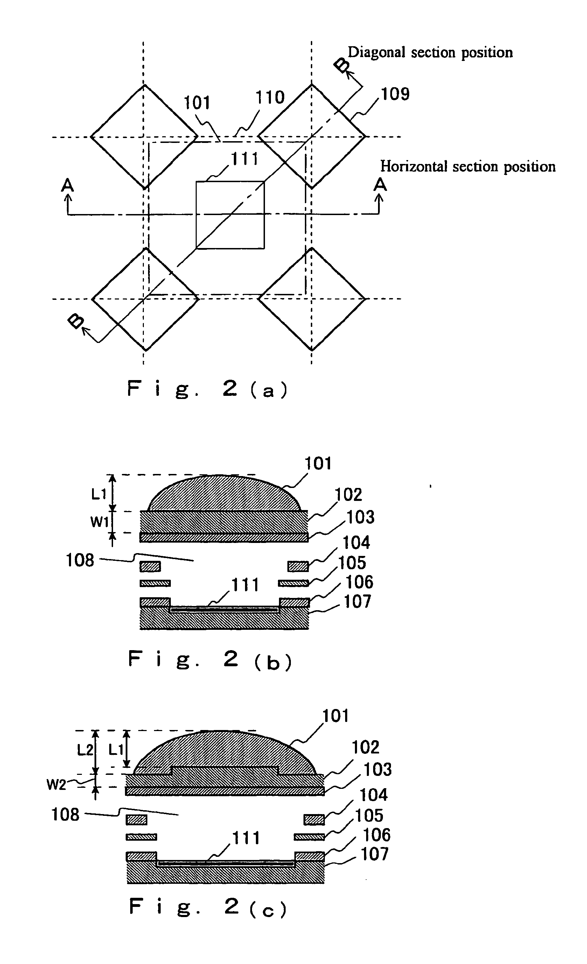

A first embodiment of the solid state image sensor of the present invention will be described in detail by using Fig. 1 and Figs. 2.

Fig. 1 is a plane view showing the state of the solid state image sensor according to the first embodiment of the present invention seen from above. In Fig. 1, 1 denotes the solid state image sensor, 2 denotes photoelectric conversion parts each formed by a buried photodiode or the like, 3 denotes vertical CCDs vertically forwarding electric charge of signal generated in the photoelectric conversion parts 2; 4 denotes a horizontal CCD horizontally forwarding the electric charge of signal forwarded from the vertical CCDs 3; 5 denotes an output amplifier, 6 denotes pixels, and 60 denotes units of pixel in terms of an area where light is condensed. Further, a microlens, though not shown in Fig. 1, is disposed above each of the photoelectric conversion parts 2 via a planarizing layer.

Each of the pixels 6 has part of the photoelectric conversion part 2 and part of the vertical CCD 3, and the plural pixels 6 are two-dimensionally arranged. Each of the microlenses is disposed with its center aligned with a center of the photoelectric conversion part 2. Therefore, the unit of pixel is an area denoted by the reference numeral 60 if defined in terms of an area where light is condensed. Here, the unit of pixel is shown as having a rectangular shape for easier understanding, but actually, the unit of pixel has a square shape, and in the following drawings, a square area where light is condensed is shown as the unit of pixel.

An electrode for controlling the forwarding of the electric charge by the vertical CCDs 3 includes a first polysilicon electrode (not shown) and a second polysilicon electrode (not shown), similarly to that in a typical solid state image sensor of a CCD type. Further, peripheral circuits and so on for generating a driving pulse and the like are further included in the solid state image sensor 1, but are not shown in the drawings since they are not essential parts of the present invention.
It should be noted that the present invention is not limited to the solid state image sensor of a CCD type, and the same effect of the present invention can also be obtained in solid state image sensors of a CMOS type and so on.

Next, Figs. 2 are views showing the unit of pixel 60 in Fig. 1 in detail, Fig. 2(a) being a plane view of the unit of pixel 60 seen from above, Fig. 2(b) being a horizontal sectional view of the unit of pixel 60 taken along a horizontal section position A in Fig. 2(a), and Fig. 2(c) being a diagonal sectional view of the unit of pixel 60 taken along a diagonal section position B in Fig. 2(a).
In Figs. 2(a), (b), and (c), 101 denotes the microlens, 102 denotes a planarizing layer under the microlens 101, 103 denotes a color filter, 104 denotes a shading film serving also as a power supply wiring, 105 denotes a wiring, 106 denotes a shading film, 107 denotes a semiconductor substrate, 108 denotes a planarizing layer between the photoelectric conversion part 111 and the color filter 103, 109 denotes concave parts of the planarizing layer 102, L1 denotes a thickness of the microlens 101 on a part other than the concave parts 109 of the planarizing layer 102, L2 denotes a thickness of the microlens 101 on the concave parts 109 of the planarizing layer 102, W1 denotes a thickness of the part other than the concave parts 109 of the planarizing layer 102, and W2 denotes a thickness of the concave parts 109 of the planarizing layer 102.

In Figs. 2, in a case of the horizontal section position A in Fig. 2(b), the microlens 101 works as a lens with the thickness L1, but in a case of the diagonal section position B in Fig. 2(c), the microlens 101 works as a lens with the thickness L2 since, in four corners of the planarizing layer 102 and the microlens 101, the thickness of the planarizing layer 102 is W2 smaller than the thickness W1.
Incidentally, the microlens 101 and the planarizing layer 102 are substantially equal in refractive index since the former is formed of, for example, a photoresist and the latter is formed of, for example, acrylic family resin, and hence, the microlens 101 and the planarizing layer 102 can be recognized as an integrated lens.

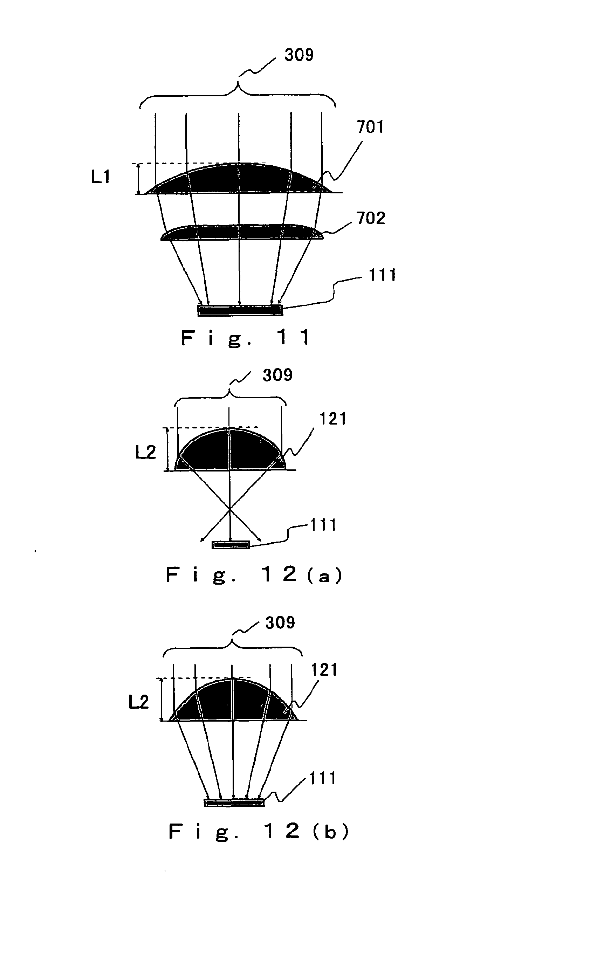

Here, an effect brought about by the difference between the thickness of the microlens 101 along the horizontal section position A and the thickness of the microlens 101 along the diagonal section position B will be described in detail by using Figs. 13 and Figs. 12. In the description of the conventional art, the optical condensing condition in a case where the lens thickness in Figs. 13(b) and (c) is L1 is described, and Figs. 12, on the other hand, show an optical condensing condition in a case where a microlens 121 whose lens thickness is L2 larger than the thickness L1 is used. Fig. 12(a) shows a horizontal section shape of the microlens 121 with the thickness L2, and Fig. 12(b) shows a diagonal section shape of the microlens 121 with the thickness L2, in both of which the same components as those in Figs. 13 are denoted by the same reference numerals used in Figs. 13.

In the conventional art, it is described that, if the thickness of the microlens 701 is set to L1 for efficient optical condensing by the horizontal section shape as shown in Fig. 13(b), optical condensing by the diagonal section shape becomes poorer as shown in Fig. 13(c). If, in turn, the thickness of the microlens 121 is set to the thickness L2 larger than L1 for efficient optical condensing by the diagonal section shape as shown in Fig. 12(b), a curvature radius becomes excessively small, and consequently, optical condensing by the horizontal section shape becomes poor as shown in Fig. 12(a), so that it is not possible to fully condense incoming lights 309 in the photoelectric conversion part 111.

On the other hand, in a case of the first embodiment of the present invention in Figs. 2, along the horizontal section position A, the microlens 102 works as the microlens 701 with the thickness L1 in Fig. 13(b) and along the diagonal section position B, the microlens 102 works as the microlens 121 with the thickness L2 in Fig. 12(b), which makes it possible to realize good optical condensing conditions as shown in Fig. 13(b) and Fig. 12(b) both along the horizontal sectional position A and along the diagonal sectional position B.

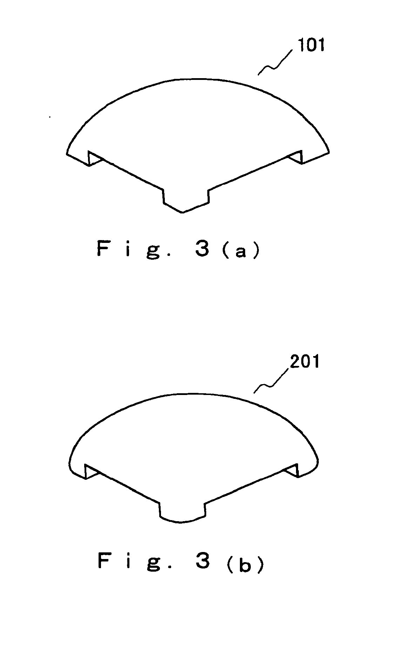

Here, the shape of the microlens 101 is shown in a perspective view in Fig. 3(a). In the present invention, a microlens 201 in Fig. 3(b) is formed by modifying the above-described microlens 101 so that its four corners are rounded, and an effect of lens near the four corners are almost the same and therefore, the same effect can be obtained by this shape.
Further, in this embodiment, the planarizing layer 102 has a double-level structure with the thickness W1 and the thickness W2, but the same effect can be obtained by the planarizing layer 102 with a multi-level structure and by the planarizing layer 102 with continuous inclinations. Such a shape can be realized by a conventionally known typical processing method such as etching, and for example, in the first embodiment, such a shape can be realized in such a manner that the planarizing layer 102 with the thickness W1 is first formed and then its periphery is removed by etching with its center part masked, and repeating this process enables the processing of the planarizing layer 102 into a multi-level structure. Another possible method to form a planarizing layer with two levels or more may be, Instead of processing the planarizing layer 102 as one thick planarizing layer, to process planarizing layers on the respective levels and accumulate these planarizing layers. The microlens 101 can also be realized by a conventionally known processing method, and for example, in the first embodiment, after the planarizing layer 102 having the thicknesses W1 and W2 is formed, a layer made of a photoresist or the like which is a base material of the microlens 10 is put over-the planarizing layer 102, and is heated by reflow or the like, and as a result, this layer flows down to enter low-level parts with W2 of the planarizing layer 102, whereby the microlens 101 can be formed.

As described above, according to the solid state image sensor of the present invention, even if the shape of a pixel is quadrangular, an focusing efficiency in four corners is improved and a solid state image sensor capable of having a good focusing efficiency can be provided, and consequently, signal output from a photoelectric conversion part is increased even with the same amount of light, enabling improved sensitivity of the solid state image sensor.

### (Second Comparative Embodiment)

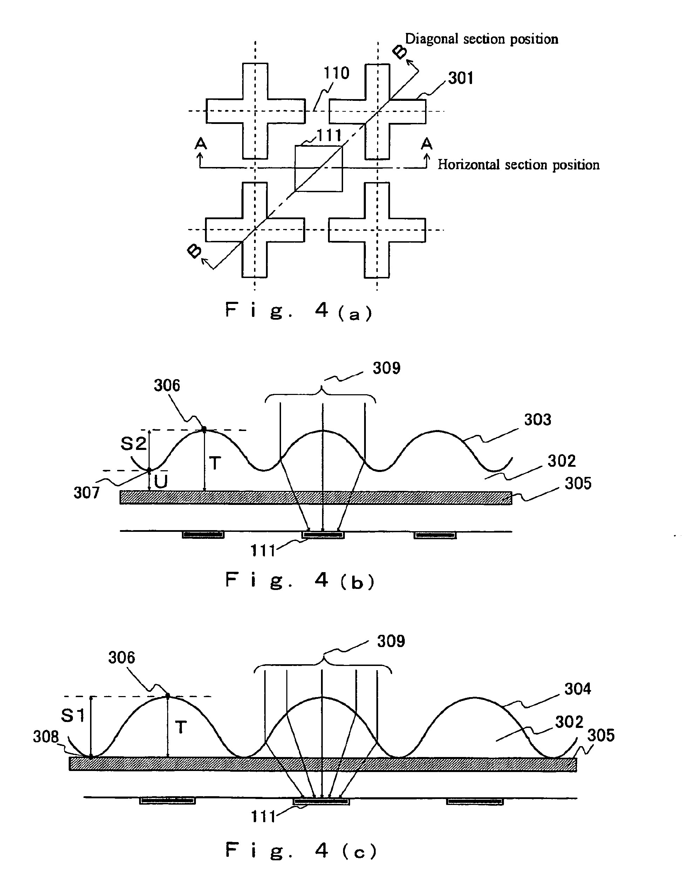

Next, a second comparative embodiment of the solid state image sensor not making part of the present invention will be described in detail by using Figs. 4. Fig. 4(a) is a plane view of a unit of pixel 60 of the solid state image sensor of the present invention seen from above, Fig. 4(b) is a horizontal sectional view of the unit of pixel 60 of the solid state image sensor having a microlens, taken along a horizontal section position A in Fig. 4(a), and Fig. 4(c) is a diagonal sectional view of the unit of pixel 60 of the solid state image sensor, taken along a diagonal section position B in Fig. 4(a).

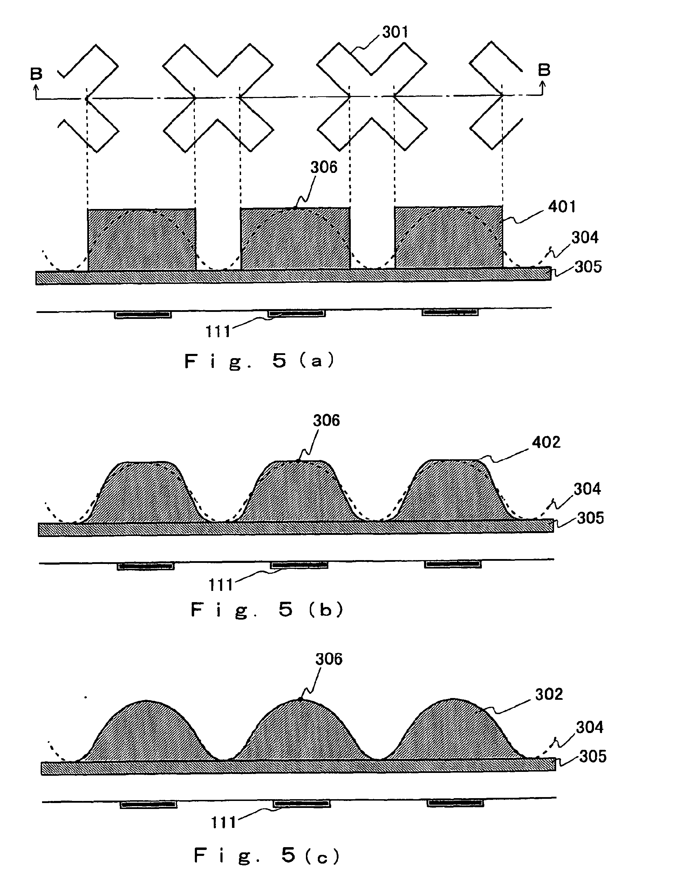

In Figs. 4(a), (b), and (c), 302 denotes the microlens, 301 denotes concave parts (to be described in detail in Figs. 5), 303 denotes a horizontal lens shape of the microlens 302 taken along the horizontal section position A, 304 denotes a diagonal lens shape of the microlens 302 taken along the diagonal section position B, 305 denotes a planarizing layer, 306 denotes an apex position of the microlens 302, 307 denotes a lowest position of the horizontal lens shape 303, 308 denotes a lowest position of the diagonal lens shape 304, T denotes the maximum thickness of the microlens 302 from a microlens 302 side surface of the planarizing layer 305, S1 denotes a difference in thickness between the lowest position 308 and the apex position 306 of the diagonal lens shape 304, S2 denotes a difference in thickness between the lowest position 307 and the apex position 306 of the horizontal lens shape 303, U denotes a thickness from the microlens 302 side surface of the planarizing layer 305 to the lowest position 307. Incidentally, a color filter, shading films, wirings, and so on are omitted in Figs. 4 to avoid making the description difficult to understand.

As shown in Fig. 4(b), along the horizontal section position A, the microlens 302 has the lens thickness S2 smaller than the lens thickness S1, and as shown in Fig. 4(c), along the diagonal section position B, the microlens 302 has the lens thickness S1 larger than the lens thickness S2. That is, where the horizontal section position A, the microlens 302 works as a lens having the horizontal section shape of the microlens 701 in Fig. 13(b) with the small thickness L1, and where the diagonal section position B, it works as a lens having the diagonal section shape of the microlens 121 in Fig. 12(b) with the large thickness L2, and therefore, it is possible to realize good optical condensing conditions as shown in Fig. 13(b) and Fig. 12(b) both along the horizontal section position A and along the diagonal section position B.

Here, a method of realizing the microlens 302 having the horizontal lens shape 303 and the diagonal lens shape 304 as shown in Figs. 4(b) and (c) will be described in detail by using Figs. 5, Figs. 6, and Figs. 7.
Figs. 5 are explanatory views showing the state of the molding into the diagonal lens shape 304 in a view taken along the diagonal section position B shown in Fig. 4(c), Fig. 5(a) being a view in which a positional relation with a photoresist layer 401 as a base material of the microlens 302 is shown in an easily understandable manner in contrast to the diagonal section position B in Figs. 4, and the photoresist layer 401 is formed in regions around the apex positions 306 of the diagonal lens shape 304, but the photoresist layer 401 is not formed in the concave parts 301. Applying heat by reflow in this state softens the photoresist layer 401, so that its corner portions begin to flow down, resulting in the shape of 402 in Fig. 5(b). As heat is further applied by reflow, the portions flowing down fill the concave parts 301, and finally, the microlens 302 having the diagonal lens shape 304 as shown in Fig. 5(c) is formed. It should be noted that these explanatory views depict the states in a schematic and easily understandable manner, and do not correctly depict the actual conditions of the flowing down state and so on.

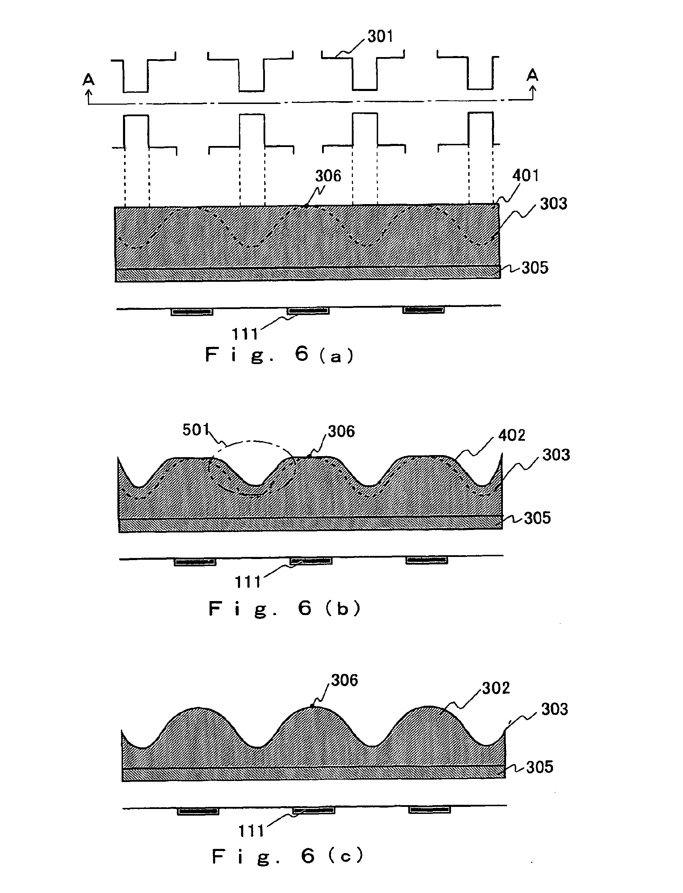

Next, the state of the molding into the horizontal lens shape 303 in a view taken along the horizontal section position A in Fig. 4(b) will be described by using Figs. 6. Fig. 6(a) is a view showing a positional relation with the photoresist layer 401 along the horizontal section position A in Figs. 4 in a contrast manner, and since the photoresist layer 401 along the horizontal section position A does not include the concave part 301, its thickness is even without any concave. Applying reflow in this state softens the photoresist layer 401, so that each part of a dashed-line circle 501 gets gradually dented, though not shown in Fig. 6(b), so that the shape of the photoresist layer 401 changes into the shape of the photoresist layer 402.

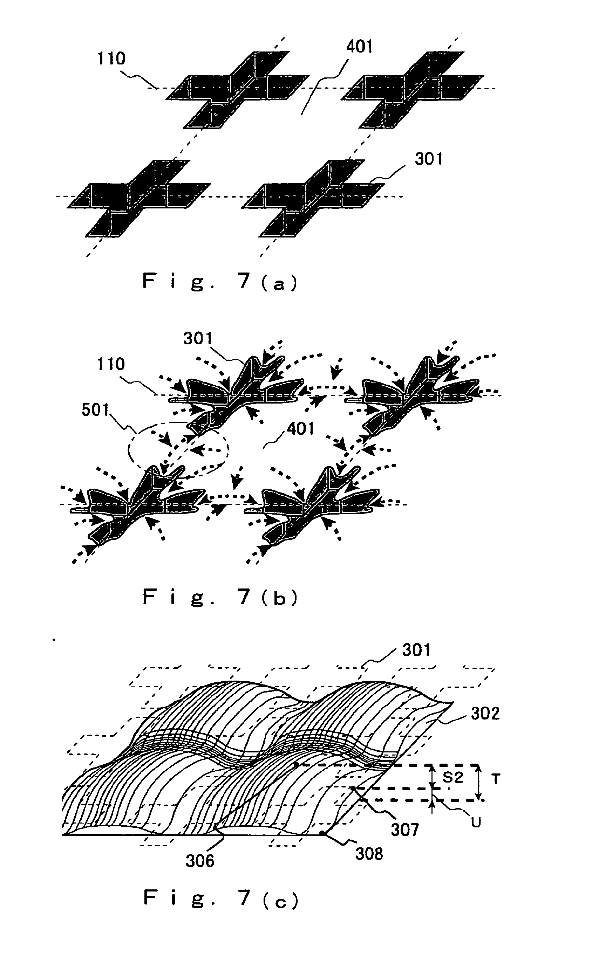

Here, the state of this change will be simply described by using Figs. 7. Figs. 7 are explanatory views schematically depicting how the concave parts 301 deform by the application of the reflow. Prior to the application of the reflow, the concave parts 301 are geometrically cut off by etching or the like as shown in Fig. 7(a), but applying heat by the reflow softens the photoresist layer 401 and its corner portions begin to flow down to become rounded in the manner of the dotted arrows as shown in Fig. 7(b), and in particular, each portion of the dashed-line circle 501 in Fig. 7(b) begins to be dented, being pulled by the concave parts 301 on both sides.

As a result of further application of heat by reflow, the concave parts 301 get gradually filled, so that the microlens 302 having the horizontal lens shape 303 as shown in Fig. 6(c) is formed. This state is shown in Fig. 7(c). Fig. 7(c) shows the lens shape in wireframe, and along the horizontal section position A, the reflow does not make the lens bottom completely flat relative to the maximum thickness T of the lens apex positions 306; and at the lowest positions 307 of the horizontal lens shape 303, the thickness is larger than the thickness of four corner portions which are the lowest positions 308 of the diagonal lens shape 304, by the thickness U of the lowest positions 307, so that the microlens works as a lens with the thickness S2.

As described above, the thickness of the microlens 302 along the horizontal section position A and the thickness of the microlens 302 along the diagonal section position B are different, and the microlens 302 along the horizontal section position A works as a thin lens with the thickness L1 of the microlens 701 shown in Fig. 13(b), and the microlens 302 along the diagonal section position B works as a thick lens with the thickness L2 of the microlens 121 shown in Fig. 12(b), and therefore, it is possible to realize good optical condensing conditions as shown in Fig. 13(b) and Fig. 12(b) both along the horizontal section position A and along the diagonal section position B.

### (Third Embodiment)

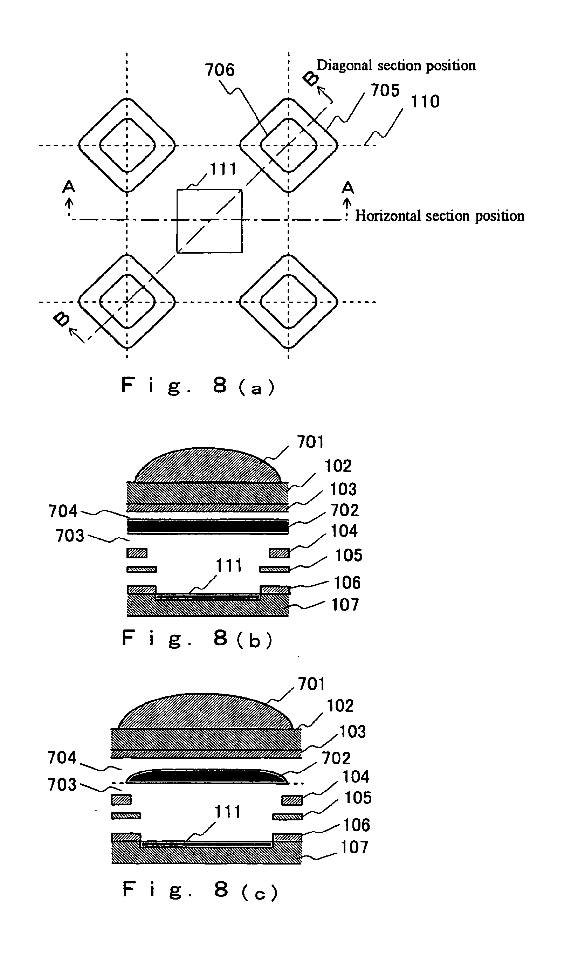

Next, a third embodiment of the solid state image sensor of the present invention will be described in detail by using Figs. 8. Fig. 8(a) is a plane view of a unit of pixel 60 of the solid state image sensor of the present invention seen from above, Fig. 8(b) is a horizontal sectional view of the unit of pixel 60 of the solid state image sensor taken along a horizontal section position A in Fig. 8(a), and Fig. 8(c) is a diagonal sectional view of the unit of pixel 60 of the solid state image sensor taken along a diagonal section position B in Fig. 8(a).

In Figs. 8(a), (b), and (c), 701 denotes a microlens, 702 denotes a second lens, 703 and 704 denote planarizing layers, 705 denotes slanting parts (to be described in detail later) of the second lens 702, and 706 denotes concave parts (to be described in detail later) of the second lens 702. Those denoted by the same reference numerals as those described in the first embodiment and the second comparative embodiment described above have the same functions and therefore, detailed description thereof will be omitted.

In Figs. 8, the microlens 701 is a typical quadrangular microlens described in the conventional art in Figs. 13, but is molded so that the microlens 701 along the horizontal section position A condenses lights efficiently in the photoelectric conversion part 111 as described in the conventional art in Fig. 13(b). Therefore, it is assumed that there arises a problem that along the diagonal section position B, sufficient optical condensing is not enabled in the vicinity of four corners of the photoelectric conversion part 111 as shown in Fig. 13(c).

In Figs. 8, the planarizing layers 703 and 704 are formed of, for example, oxide silicon or the like and have a refractive index of about 1.5, and the second lens 702 therebetween is formed of, for example, nitride silicon having a different refractive index and has a refractive index of about 2, and therefore, the second lens 702 works as a lens. Incidentally, the second lens 702 is formed to have a desired shape by a generally used processing method such as etching.

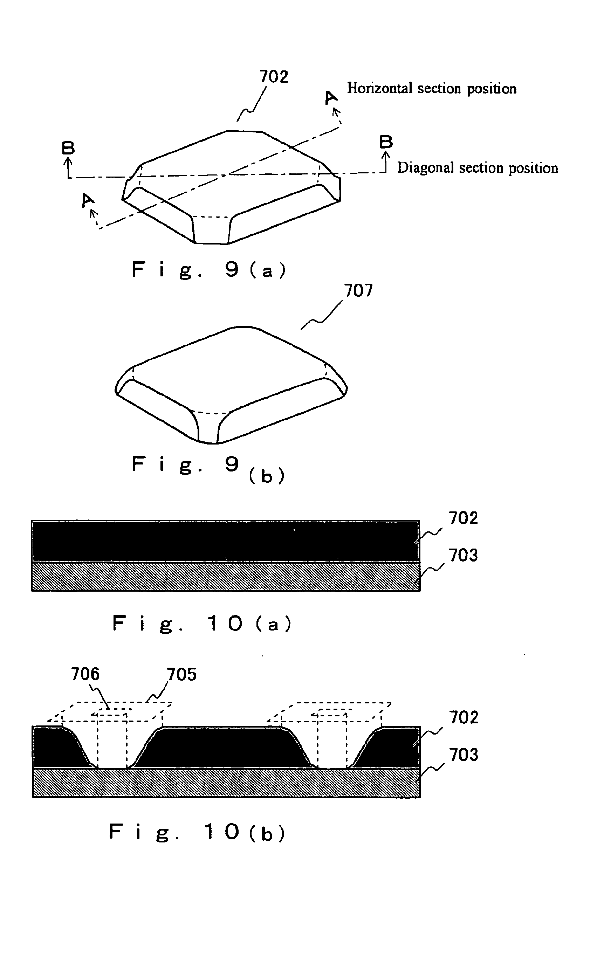

Here, the shape of the second lens 702 will be described in detail by using Figs. 9 and Figs. 10. In Fig. 9(a), which is a perspective view of the second lens 702, along the position of the horizontal section position A, the second lens 702 does not vary in thickness and is only a planar layer, but along the position of the diagonal section position B, has inclinations at corner portions thereof, and thus has an effect of lens in these portions. A sectional view of the second lens 702 taken along the horizontal section position A in Fig. 9(a) is shown in Fig. 10(a), and a sectional view of the second lens 702 taken along the diagonal section position B in Fig. 9(a) is shown in Fig. 10(b). In Fig. 10(a), the second lens 702 is formed on the planarizing layer 703, but the second lens 702 is a flat layer and does not work as a lens. That is, along the horizontal section position A, only the microlens 701 contributes to optical condensing in the photoelectric conversion part 111, and therefore, efficient optical condensing in the photoelectric conversion part 111 is made possible as shown in Fig. 13(b).

On the other hand, in Fig. 10(b), the second lens 702 is formed on the planarizing layer 703, but the layer of the second lens 702 does not exist at portions positioning in the concave parts 706 in Figs. 8, and in areas of slanting parts 705 excluding the concave parts 706 in Figs. 8, the layer of the second lens 702 is slanted so as to get gradually thinner toward the concave parts 706. That is, the second lens 702 has an effect of lens only near the slanting four corners, even though its portions excluding the concave parts 706 and the slanting parts 705 are substantially flat and thus have almost no effect of lens.

As described above, along the diagonal section position B, the combination of optical condensing by the microlens 701 and optical condensing by the effect of lens of the four corner portions of the second lens 702 contribute to optical condensing in the photoelectric conversion part 111, and therefore, though, only with the microlens 701, efficient optical condensing in four corner portions of the photoelectric conversion part 111 is not possible as shown in Fig 13(c), this is corrected by the effect of lens of the four corner portions of the second lens 702, resulting in two-stage optical condensing as shown in Figs. 11, which enables efficient optical condensing in the photoelectric conversion part 111.

The second lens 702 of the third embodiment has a shape with the four corners being cut off along straight lines as shown in Fig. 9(a), but the second lens 702 having a shape with rounded corners as shown in Fig. 9(b) have the same effect of lens near the four corners, and thus can provide the same effect as that of the third embodiment.

## Claims

1. A solid state image sensor comprising:
a pixel (60) formed on a semiconductor substrate;
a photoelectric conversion part (111) provided in said pixel to convert light to an electric signal; and
a microlens (101, 102) provided above said photoelectric conversion part (111),
**characterised in that**
said microlens (101, 102) has a plane shape when seen from above with a direct distance from a center to a lens edge being varied, the plane shape when seen from above being a quadrangle with rounded four corners;
said microlens (101, 102) has a first base region and a second base region not including said first base region, in which said first base region is provided near said four corners of said quadrangle, and said second base region includes four sides of said quadrangle; and
a vertical height of said first base region from an upper surface of said photoelectric conversion part (111) is lower than a vertical height of said second base region from the upper surface of said photoelectric conversion part (111).

2. The solid state image sensor according to claim 1, wherein
the vertical height from the upper surface of said photoelectric conversion part (111) decreases stepwise from said second base region toward said first base region.

3. The solid state image sensor according to claim 1, wherein
the vertical height from the upper surface of said photoelectric conversion part (111) continuously decreases from said second base region to said first base region.

4. The solid state image sensor according to any one of claims 1 to 3, wherein
a planarizing layer (102) is provided between said photoelectric conversion part (111) and said microlens (101, 102); in which
said planarizing layer has a first region and a second region not including said first region, said first region being opposed to said first base region located near said four corners of said quadrangle onto which said plane shape when seen from above of said quadrangle with said rounded four corners of said microlens (101, 102) is vertically projected, and said second top surface being opposed to said second base region including said four sides of said quadrangle; and
a thickness of said planarizing layer is larger in said second region toward a microlens side than in said first region.

5. The solid state image sensor according to claim 4, wherein
the thickness of said planarizing layer decreases stepwise from said second region toward said first region.

6. The solid state image sensor according to claim 4, wherein
the thickness of said planarizing layer continuously decreases from said second region toward said first region.

7. A solid state image sensor comprising:
a pixel (60) formed on a semiconductor substrate;
a photoelectric conversion part (111) provided in said pixel to convert light to an electric signal; and
a microlens (701) provided above said photoelectric conversion part (111),
**characterised in that**
said microlens (701) has a plane shape when seen from above with a direct distance from a center to a lens edge being varied,
a planarizing layer (703, 704) provided between said photoelectric conversion part (111) and said microlens (701), wherein:
in said planarizing layer (703, 704), a second lens (702) is provided in parallel to said photoelectric conversion part (111), with an optical axis of the second lens (702) aligned with an optical axis of said microlens (701); and
said second lens (702) has a plane shape when seen from above with a direct distance from a center to a lens edge being varied, the plane shape when seen from above being a quadrangle with cut-off or rounded four corners, and is made of a member larger in refractive index than said planarizing layer (703, 704), wherein:
said second lens (702) has first region and a second region not including said first region and said second region is slanted so as to become thinner from said second region to four corners of said second lens (702, 707) which are said first region, in which said first region is near said four corners of said quadrangle and said second region includes said four sides of said quadrangle.

8. The solid state image sensor according to claim 7, wherein:
said second region is substantially planar; and
said first region in said second lens are slanted so as to become smaller in thickness from portions adjacent to said second region toward said first region in said four corners of said second lens.

## Patentansprüche

1. Festkörper-Bildsensor, der Folgendes umfasst:
ein Pixel (60), das auf einem Halbleitersubstrat ausgebildet ist;
einen fotoelektrischen Umwandlungsteil (111), der in dem Pixel angeordnet ist, zum Umwandeln von Licht in ein elektrisches Signal; und
eine Mikrolinse (101, 102), die über dem fotoelektrischen Umwandlungsteil (111) angeordnet ist,
**dadurch gekennzeichnet, dass**
die Mikrolinse (101, 102) - von oben betrachtet, wenn eine direkte Entfernung von einer Mitte zu einem Linsenrand variiert wird - eine Ebenenform hat, wobei die Ebenenform, von oben betrachtet, ein Viereck mit gerundeten vier Ecken ist;
die Mikrolinse (101, 102) eine erste Basisregion und eine zweite Basisregion, die nicht die erste Basisregion enthält, aufweist, wobei die erste Basisregion nahe den vier Ecken des Vierecks angeordnet ist und die zweite Basisregion vier Seiten des Vierecks enthält; und
eine vertikale Höhe der ersten Basisregion von einer Oberseite des fotoelektrischen Umwandlungsteils (111) geringer ist als eine vertikale Höhe der zweiten Basisregion von der Oberseite des fotoelektrischen Umwandlungsteils (111).

2. Festkörper-Bildsensor nach Anspruch 1, wobei die vertikale Höhe von der Oberseite des fotoelektrischen Umwandlungsteils (111) von der zweiten Basisregion in Richtung der ersten Basisregion schrittweise abnimmt.

3. Festkörper-Bildsensor nach Anspruch 1, wobei
die vertikale Höhe von der Oberseite des fotoelektrischen Umwandlungsteils (111) von der zweiten Basisregion zu der ersten Basisregion kontinuierlich abnimmt.

4. Festkörper-Bildsensor nach einem der Ansprüche 1 bis 3, wobei
eine Planarisierungsschicht (102) zwischen dem fotoelektrischen Umwandlungsteil (111) und der Mikrolinse (101, 102) angeordnet ist; wobei
die Planarisierungsschicht eine erste Region und eine zweite Region, die nicht die erste Region enthält, aufweist, wobei die erste Region der ersten Basisregion, die sich nahe den vier Ecken des Vierecks befindet, auf die die Ebenentorm - von oben betrachtet - des Vierecks mit den gerundeten vier Ecken der Mikrolinse (101, 102) vertikal projiziert wird, gegenüberliegt und die zweite Oberseite der zweiten Basisregion, die die vier Seiten des Vierecks enthält, gegenüberliegt; und
eine Dicke der Planarisierungsschicht in der zweiten Region in Richtung einer Mikrolinsenseite größer ist als in der ersten Region.

5. Festkörper-Bildsensor nach Anspruch 4, wobei die Dicke der Planarisierungsschicht von der zweiten Region in Richtung der ersten Region schrittweise abnimmt.

6. Festkörper-Bildsensor nach Anspruch 4, wobei
die Dicke der Planarisierungsschicht von der zweiten Region in Richtung der ersten Region kontinuierlich abnimmt.

7. Festkörper-Bildsensor, der Folgendes umfasst:
ein Pixel (60), das auf einem Halbleitersubstrat ausgebildet ist;
einen fotoelektrischen Umwandlungsteil (111), der in dem Pixel angeordnet ist, zum Umwandeln von Licht in ein elektrisches Signal; und
eine Mikrolinse (701), die über dem fotoelektrischen Umwandlungsteil (111) angeordnet ist,
**dadurch gekennzeichnet, dass**
die Mikrolinse (701) - von oben betrachtet, wenn eine direkte Entfernung von einer Mitte zu einem Linsenrand variiert wird - eine Ebenenform hat,
eine Planarisierungsschicht (703, 704) zwischen dem fotoelektrischen Umwandlungsteil (111) und der Mikrolinse (701) angeordnet ist, wobei:
in der Planarisierungsschicht (703, 704) eine zweite Linse (702) parallel zu dem fotoelektrischen Umwandlungsteil (111) angeordnet ist, wobei eine optische Achse der zweiten Linse (702) auf eine
optische Achse der Mikrolinse (701) ausgerichtet ist; und
die zweite Linse (702) - von oben betrachtet, wenn eine direkte Entfernung von einer Mitte zu einem Linsenrand variiert wird - eine Ebenenform hat, wobei die Ebenenform, von oben betrachtet, ein Viereck mit abgeschnittenen oder gerundeten vier Ecken ist und aus einem Element besteht, dessen Brechungsindex größer ist als der Brechungsindex der Planarisierungsschicht (703, 704), wobei:
die zweite Linse (702) eine erste Region und eine zweite Region, die nicht die erste Region enthält, aufweist, und die zweite Region so geneigt ist, dass sie von der zweiten Region zu vier Ecken der zweiten Linse (702, 707), die die erste Region sind, dünner wird, wobei die erste Region nahe den vier Ecken des Vierecks angeordnet ist und die zweite Region die vier Seiten des Vierecks enthält.

8. Festkörper-Bildsensor nach Anspruch 7, wobei:
die zweite Region im Wesentlichen planar ist; und
die erste Region in der zweiten Linse so geneigt ist, dass ihre Dicke von Abschnitten neben der zweiten Region in Richtung der ersten Region in den vier Ecken der zweiten Linse kleiner wird.

## Revendications

1. Capteur d'image à semi-conducteur, comprenant :
un pixel (60) forme sur un substrat semi-conducteur ;
une partie conversion photoélectrique (111) prévue dans ledit pixel, pour convertir une lumière en un signal électrique ; et
une microlentille (101, 102) prévue au-dessus de ladite partie conversion photoélectrique (171) ;
**caractérisé en ce que** :
ladite microlentille (101, 102) présente une forme plane quand on la regarde à partir du dessus, la distance directe à partir du centre jusqu'à un bord de la lentille étant variable, la forme plane quand on la regarde à partir du dessus étant un quadrilatère présentant quatre coins arrondis ;
ladite microlentille (101, 102) présente une première région de base et une seconde région de base qui ne comprend pas ladite première région de base, dans lequel ladite première région de base est prévue à proximité desdits quatre coins dudit quadrilatère, et ladite seconde région de base comprend quatre côtés dudit quadrilatère ; et
la hauteur verticale de ladite première région de base à partir d'une surface supérieure de ladite partie conversion photoélectrique (111) est inférieure à la hauteur verticale de ladite seconde région de base à partir de la surface supérieure de ladite partie conversion photoélectrique (111).

2. Capteur d'image à semi-conducteur selon la revendication 1, dans lequel :
la hauteur verticale à partir de la surface supérieure de ladite partie conversion photoélectrique (111) diminue par paliers à partir de ladite seconde région de base vers ladite première région de base.

3. Capteur d'image à semi-conducteur selon la revendication 1, dans lequel
la hauteur verticale à partir de la surface supérieure de ladite partie conversion photoélectrique (111) diminue de manière continue à partir de ladite seconde région de base vers ladite première région de base.

4. Capteur d'image à semi-conducteur selon l'une quelconque des revendications 1 à 3, dans lequel :
une couche de planarisation (102) est prévue entre ladite partie conversion photoélectrique (111) et ladite microlentille (101, 102) ; dans lequel
ladite couche de planarisation présente une première région et une seconde région qui ne comprend pas ladite première région, ladite première région étant opposée à ladite première région de base située à proximité desdits quatre coins dudit quadrilatère sur lequel est projetée verticalement ladite forme plane quand on la regarde à partir du dessus dudit quadrilatère avec lesdits quatre coins arrondis de ladite microlentille (101, 102), et ladite seconde surface supérieure étant opposée à ladite seconde région de base qui comprend lesdits quatre côtés dudit quadrilatère ; et
l'épaisseur de ladite couche de planarisation est plus grande dans ladite seconde région vers un côté de la microlentille que dans ladite première région.

5. Capteur d'image a semi-conducteur selon la revendication 4, dans lequel :
l'épaisseur de ladite couche de planarisation diminue par paliers à partir de ladite seconde région vers ladite première région.

6. Capteur d'image à semi-conducteur selon la revendication 4, dans lequel :
l'épaisseur de ladite couche de planarisation diminue de manière continue à partir de ladite seconde région vers ladite première région.

7. Capteur d'image à semi-conducteur, comprenant :
un pixel (60) formé sur un substrat semi-conducteur,
une partie conversion photoélectrique (111) prévue dans ledit pixel pour convertir une lumière en un signal électrique ; et
une microlentille (701) prévue au-dessus de ladite partie conversion photoélectrique (111) ;
**caractérisé en ce que** :
ladite microlentille (701) présente une forme plane quand on la regarde à partir du dessus, la distance directe à partir du centre jusqu'à un bord de la lentille étant variable ;
une couche de planarisation (703, 704) est prévue entre ladite partie conversion photoélectrique (111) et ladite microlentille (701), dans lequel :
dans ladite couche de planarisation (703, 704), une seconde lentille (702) est prévue en parallèle avec ladite partie conversion photoélectrique (111), l'axe optique de la seconde lentille (702) étant aligné avec l'axe optique de ladite microlentille (701) ; et
ladite seconde lentille (702) présente une forme plane quand on la regarde à partir du dessus, la distance directe à partir du centre jusqu'à un bord de la lentille étant variable, la forme plane quand on la regarde à partir du dessus étant un quadrilatère avec quatre coins coupés ou arrondis, et est constituée d'un élément présentant un indice de réfraction plus grand que celui de ladite couche de planarisation (703, 704), dans lequel :
ladite seconde lentille (702) présente une première région et une seconde région qui ne comprend pas ladite première région et ladite seconde région est inclinée de façon à devenir plus mince à partir de ladite seconde région vers les quatre coins de ladite seconde lentille (702, 707) qui sont dans ladite première région, dans laquelle ladite première région est située à proximité desdits quatre coins dudit quadrilatère et ladite seconde région comprend lesdits quatre côtés dudit quadrilatère.

8. Capteur d'image à semi-conducteur selon la revendication 7, dans lequel :
ladite seconde région est sensiblement plane ; et
ladite première région dans ladite seconde lentille est inclinée de façon à présenter une épaisseur plus petite à partir des parties adjacentes à ladite seconde région vers ladite première région dans lesdits quatre coins de ladite seconde lentille.
